# EUROPEAN PATENT APPLICATION

(11) **EP 0 531 018 A2**
(43) Date of publication of application: **10.03.1993**
(21) Application number: 92307562.6
(22) Date of filing: 19.08.1992
(51) Int. Cl.: H01L 21/76, H01L 21/20, H01L 21/306

(54) **Method for production of dielectric-separation substrate**

(30) Priority: 31.08.1991 JP 247070/91
(71) Applicant: SHIN-ETSU HANDOTAI COMPANY LIMITED, Chiyoda-ku Tokyo (JP)
(72) Inventor: Ohta, Yutaka, Annaka-shi, Gunma-ken (JP); Ohki, Konomu, Annaka-shi, Gunma-ken (JP); Katayama, Masatake, Takasaki-shi, Gunma-ken (JP)
(74) Representative: Pacitti, Pierpaolo A.M.E.

(57) **Abstract**

A dielectric-separation substrate which precludes the occurrence of dents conforming to grooves in the polished surface of a polycrystalline silicon layer or in the surface of an oxide film or the formation of voids in the bonding face and, therefore, enjoys perfectly reliable bonding strength of device-forming layers with the substrate is produced by a method which comprises forming grooves in the surface of a single crystal silicon substrate, covering the grooves with a separate oxide film, superposing thereon a polycrystalline silicon layer to the extent of causing the grooves to be buried completely therein, grinding the surface of the polycrystalline silicon layer with a surface grinder, forming an oxide film on the ground surface of the polycrystalline silicon layer, then polishing the surface of the oxide film thereby converting the surface into a flat and smooth surface, further bonding face to face to the flat and smooth surface of the oxide film a desired substrate intended to form a supporting member, and grinding and polishing the single crystal silicon substrate from the rear side thereby giving rise to single crystal silicon regions separated one from another after the pattern of islands in an ocean by intervening portions of the oxide film.

## Description

### BACKGROUND OF THE INVENTION

### FIELD OF THE INVENTION:

This invention relates to a method for the production of a dielectric-separation substrate.

### DESCRIPTION OF THE PRIOR ART:

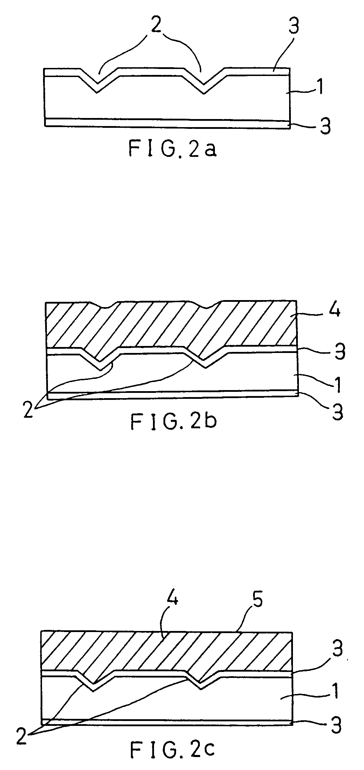

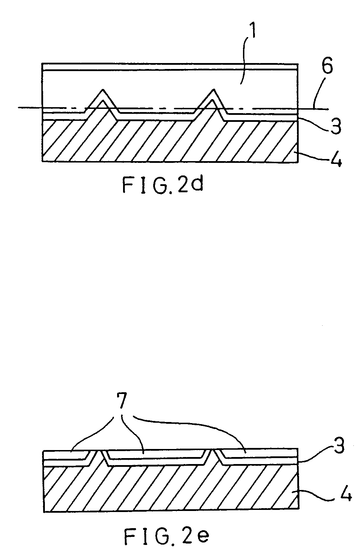

The method generally employed for the production of a dielectric-separation substrate, as illustrated in Fig. 2, comprises first forming an oxide film 3 on the surface of a single crystal silicon substrate 1 having grooves 2 formed at pertinent portions thereof as by anisotropic etching [Fig. 2a], superposing a polycrystalline silicon layer of a thickness substantially equal to that of the substrate on the surface of the single crystal silicon substrate 1 with the oxide film 3 therebetween thereby forming a supporting member 4 [Fig. 2b], and further grinding and/or polishing the surface portion of the polycrystalline silicon supporting member 4 thereby giving a substantially flat surface 5 to the supporting member 4 [Fig. 2 c].

It further comprises grinding and polishing the single crystal silicon substrate 1 from the rear side to the extent of exposing part of the grooves 2, namely as far as a boundary plane 6 in which part of the polycrystalline silicon supporting member 4 is exposed through the bottoms of the grooves 2, thereby converting the silicon substrate 1 into a thin film [Fig. 2d] and giving rise to single crystal silicon regions 7 electrically separated one from another after the pattern of islands in an ocean by intervening portions of the oxide film 3 [Fig. 2e].

However, the single crystal silicon substrate 1 on which the polycrystalline silicon has been superposed in a thickness substantially equal to that of the substrate is largely warped in such a manner as to form a concave on the polycrystalline silicon layer 4 side owing to the difference in thermal expansion coefficient between the single crystal silicon substrate 1 and the polycrystalline silicon layer 4 and the decrease in the volume of said layer 4 resulting from the growth of polycrystalline silicon crystal grains during the process of the superposition of the polycrystalline silicon layer. This warpage increases in accordance as the diameter of the substrate increases.

This warpage jeopardizes the accuracy with which the work of polishing off intended for the formation of single crystal silicon regions in the form of islands in an ocean is carried out. This conspicuous warpage persists after the separation in the form of islands in an ocean and eventually exerts an adverse effect on the subsequent formation of electronics elements.

Further, the work of superposing on the single crystal silicon substrate 1 the polycrystalline layer in a thickness substantially equal to that of the substrate is not advantageous from the standpoint of the cost of production.

Means of improvement disclosed as in Japanese Unexamined Patent Publications No. 1,449/1988 and No. 62,252/1988, for example, have been proposed for the purpose of precluding the occurrence of a warpage in a dielectric-separation substrate due to the superposition of such a polycrystalline silicon layer as mentioned above and, at the same time, decreasing the cost of production.

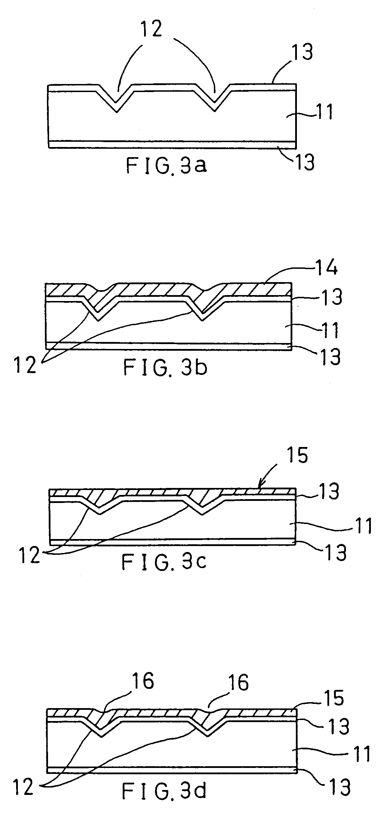

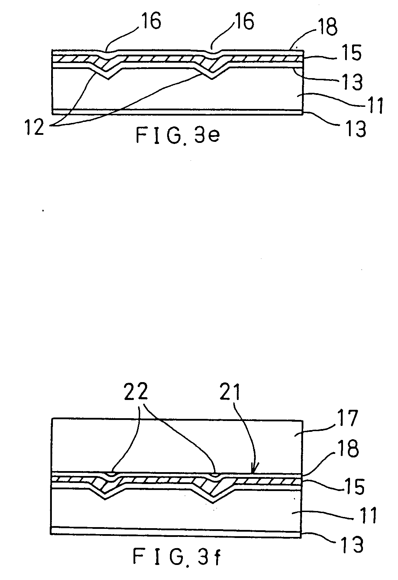

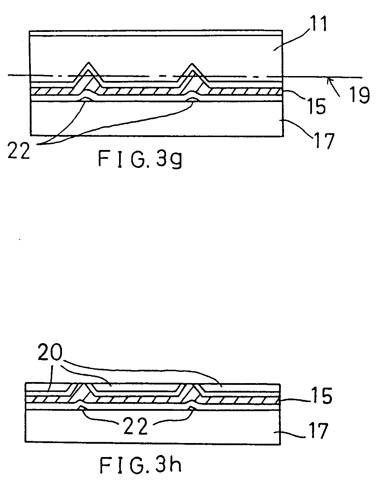

The improved method for the production of the dielectric-separation substrate, as illustrated in Fig. 3, comprises first forming an oxide film 13 on the surface of a single crystal silicon substrate 11 having grooves 12 formed in pertinent places in the same manner as in the conventional method described above [Fig. 3a], superposing on the surface of the single crystal silicon substrate 11 with the oxide film 13 covering said substrate 11 a polycrystalline silicon layer 14 in a thickness at least enough to bury the grooves 12 [Fig. 3b], grinding the surface portion of the polycrystalline silicon layer 14 thereby converting this layer into a thin film, and then polishing this thin film by mechanochemical process thereby giving a thoroughly flat and smooth surface 15 thereto [Fig. 3].

It further comprises bonding face to face to the flat and smooth surface 15 of the polycrystalline silicon layer 14 a single crystal or polycrystalline silicon substrate 17 intended as a supporting member either directly or through the medium of a thermal oxide film 18 [Fig. 3f] [the steps of Fig. 3e and Fig. 3d will be described herein below], then grinding and polishing the device-forming side of the single crystal silicon substrate 11 from the rear side similarly to the preceding example to the extent of exposing part of the grooves 12, namely as far as a boundary plane 19 in which part of the polycrystalline silicon layer 14 mentioned above is exposed through the bottoms of the grooves 12 thereby converting the silicon substrate 11 into a thin film and, at the same time, imparting a flat and smooth surface thereto [Fig. 3g] and giving rise to single crystal silicon regions 20 electrically separated one from another after the pattern of islands in an ocean by intervening portions of the oxide film 13 [Fig. 3h].

Consequently, the improved method of the production of the dielectric-separation substrate permits to restrain the occurrence of a warpage in the substrate due to the superposition of a polycrystalline silicon layer to a minimum and is suited to the production of the substance with a large diameter and, at the same time, permits to omit the process of superposing a thick polycrystalline silicon layer by a step of bonding a desired substrate, face to face, to the oxide film and, decreasing the cost of production thereby.

The present inventors, by replicating this improved method of production, have been ascertained that there are times when the polished surface of the polycrystalline silicon layer 14 does not always form a flat and smooth surface 15 and depressions 16 corresponding to the grooves 12 having a cross section of the shape of the letter V are formed in the polished surface of the polycrystalline silicon layer 14 and consequently in the surface of the thermal oxide film 18 [Fig. 3d]. This phenomenon may be logically explained by a supposition that a difference occurs in the polishing speed in the mechanochemical polishing work probably because the inner pressure is different between the portions of the single crystal substrate overlying the grooves and the portions thereof overlying the non-groove area owing to the difference in elastic constant between the single crystal and the polycrystals or because the chemical quality of polycrystals is different between the grooves and the non-groove area.

When a desired substrate 17 intended to form a supporting member is bonded face to face to the polished surface of the silicon substrate after the depressions 16 have been formed, cavities 22 are formed in the portions of a bonding face 21 which correspond to the depressions and, as a result, the disadvantage ensue that the union between the bonded surfaces loses in strength and separation subsequently occurs in the bonding face 21 during the step of grinding and polishing the single crystal silicon substrate 11 on the device-forming side thereby converting the substrate 11 into a thin film or during the step of device formation.

### SUMMARY OF THE INVENTION

This invention, produced in the urge to eliminate the drawback of the prior art described above, has as an object thereof the provision of a method for the production of a dielectric-separation substrate, which method is capable of precluding the occurrence of depressions 16 in the ground surface of the polycrystalline silicon layer 14 or surface of the thermal oxide film 18 corresponding to the grooves 12 of the V-shaped cross section and the consequent formation of cavities 22 in the bonding face 21 thereby ensuring perfect reliability of the strength of union of the device-forming substrate with the supporting member and, at the same time, warranting inexpensiveness of the production.

To accomplish the object described above, this invention provides a method for the production of a substrate with a separate dielectric, which method is characterized by comprising at least a step of forming grooves having required cross-sectional shapes in the surface portion of a single crystal silicon substrate destined to form an device-forming side thereof and, at the same time, covering the grooves with an oxide film and then superposing a polycrystalline silicon layer thereon to the extent of causing the parts corresponding to the grooves to be buried completely therein, a step of grinding the surface of the superposed polycrystalline silicon layer so as to confer flatness thereon, a step of forming an oxide film on the flat surface of the polycrystalline silicon layer and then polishing the surface of the oxide film by the mechanochemical process so as to confer flatness and smoothness thereon, a step of bonding a desired substrate prepared separately as a supporting member face to fact to the flat and smooth surface of the oxide film, and a step of grinding and polishing the single crystal silicon substrate on the device-forming side from the rear side thereby forming in the single crystal silicon substrate single crystal silicon regions dielectrically separated after the pattern of islands in an ocean by intervening portions of the oxide film.

The other objects and characteristic features of this invention will become apparent from the description of the invention to be given specifically herein below with reference to the accompanying drawings.

### BRIEF DESCRIPTION OF THE DRAWINGS

Figs. 1a to 1n are schematic sectional views illustrating the main sequential steps in a method for the production of a dielectric-separation substrate as one embodiment of this invention.

Figs. 2a to 2e are schematic sectional views illustrating the main sequential steps in a conventional ordinary method for the production of a dielectric-separation substrate.

Figs. 3a to 3h are schematic sectional views illustrating the main sequential steps in a conventional improved method for the production of a dielectric-separation substrate.

### DETAILED DESCRIPTION OF PREFERRED EMBODIMENT

When a substantially flat and smooth oxide film is formed on a flat surface which is not smooth as obtained with a surface grinder after grooving and polycrystalline silicon superposing according to this invention and this oxide film is polished by the mechanochemical process as contemplated by this invention, the oxide film is finished in a flat and smooth state because of the absence of any difference in polishing speed between the portions of the oxide film overlying the grooves and the portions thereof overlying the non-groove area. Thus, the otherwise possible occurrence of cavities during the subsequent step of face-to-face bonding of a desired substrate to the single crystal silicon substrate is precluded by this invention.

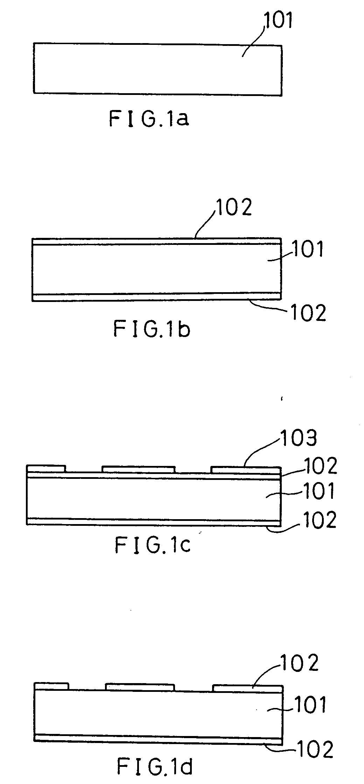

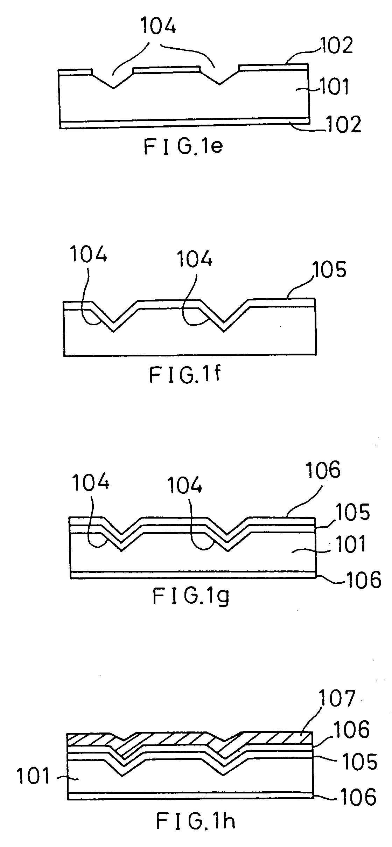

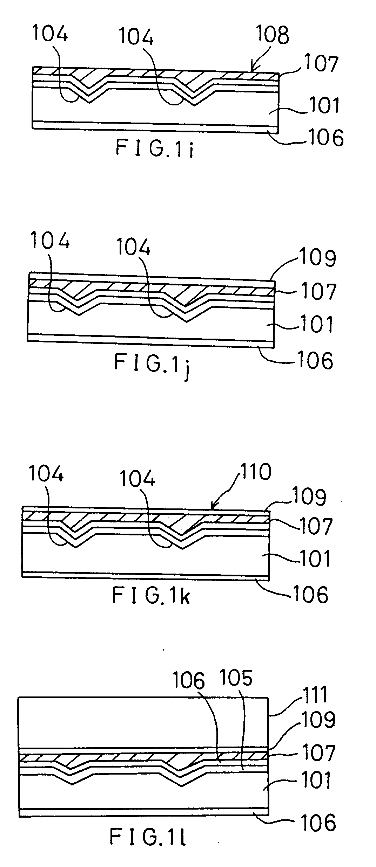

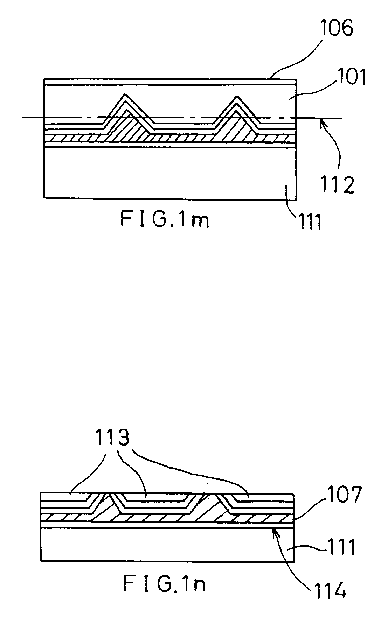

Now, the method of this invention for the production of a dielectric-separation substrate will be described more specifically herein below with reference to Fig. 1 illustrating one embodiment of this invention.

Figs. 1a to 1n are sectional schematic representations illustrating the main sequential steps in a method for the production of a dielectric-separation substrate as one embodiment of this invention.

On the surface of an n type <100> single crystal silicon substrate (625µm in thickness) 101 having a diameter of 125 mm and pulled by the CZ process [Fig. 1a], a thermal oxide film 102 was formed [Fig. 1b] and V grooves 104 having a maximum depth of about 35µm were formed by the use of a prescribed groove mask pattern of the photolithographic process and removing the material leaving the grooves by etching with an aqueous KOH solution [Figs. 1c, 1d, and 1e].

Then, the thermal oxide film 102 was removed. On the surface of the single crystal silicon substrate 101 with the V grooves 104 therein a Sb-diffused layer 105 having a sheet resistance of 20 Ω / □ and a thickness of about 4µm was formed [Fig. 1f]. Subsequently, on the Sb-diffused layer 105, an oxide film 106 having a thickness of about 2µm was formed by the thermal oxidation process [Fig. 1g].

In an epitaxial reaction vessel, a polycrystalline silicon layer 107 was deposited at 1175 °C on the oxide film 106 in a thickness of about 80 µm enough for thoroughly burying the portions corresponding to the V grooves 104 [Fig. 1h]. Then, with a surface grinder, the surface of the polycrystalline silicon layer 107 was ground until the portions overlying the non-groove area decreased to a thickness of about 20 ± 3 µm, to give rise to a flat surface 108 [Fig. 1i]. Optionally, this flat surface 108 may be further polished to be converted into a substantially flat and smooth surface.

The flat surface 108 obtained in consequence of the grinding had a roughness of not more than about 0.3 µm and a flatness of not more than about 2 µm on the TTV scale. In this case, the warpage produced a concave on the polycrystalline silicon layer 107 side. The size of this warpage on the flat surface 108 having a diameter of 125 mm was approximately 50 ± 10 µm as expressed by the difference in height between the peripheral part and the central part of the flat surface when the substrate placed horizontally the concaved surface down.

Further, the substrate which had been treated as described above was thoroughly washed. On the flat surface 108 of the polycrystalline silicon layer 107, a thermal oxide film 109 was formed by the thermal oxidation process in a thickness of about 1 to 1.5µm [Fig. 1j]. This oxide film was polished by the mechanochemical process using an abrading device to produce a flat and smooth surface (or mirror surface) 110 [Fig. 1k]. While the oxide film was formed by the thermal oxidation process in the present embodiment, it may be produced by the chemical vapor deposition process (CVD process) instead.

The warpage produced in the substrate in this case produced either a concave or convex on the surface of the polycrystalline silicon layer 107. The size of the warpage was not more than about 30µm in TTV scale as used above. The mechanochemical polishing given to the thermal oxide film 109, unlike that involved in the conventional method, did not give rise to any dent in the portions corresponding to the V grooves 104.

Subsequently, an n type <100> single crystal silicon substrate (625µm in thickness) 111 having a diameter of 125 mm and separately prepared by the CZ process was bonded face to face to the flat and smooth surface 110 of the thermal oxide film 109 in the substrate formed as described above. The resultant composite substrate was heat-treated [Fig. 11].

Thereafter, similarly to the steps of the conventional method described above, the single crystal silicon substrate 101 on the device-forming side was ground from the rear side to the extent of exposing part of the V grooves 104, namely as far as a boundary face 112 in which part of the polycrystalline silicon layer 107 was exposed through the bottoms of the V grooves 104, to convert the silicon substrate 101 into a thin film. This thin film was mechanochemically polished to acquire flatness and smoothness [Fig. 1m]. Thus, single crystal silicon regions 113 electrically separated one from another after the pattern of islands in an ocean by intervening portions of the oxide film 106 were formed [Fig. 1n], to complete a dielectric-separation substrate as aimed at by this invention.

When a bonding face 114 consequently formed in the dielectric-separation substrate which had been produced through the various steps described above was examined with an ultrasonic flaw detector and an infrared cavity detector, no flaw or cavity was found in the bonding face 114. The produced dielectric-separation substrate was found with a tensile tester to possess a bonding strength of 800 kgf/cm², corresponding the magnitude of bonding strength of the adhesive agent used in the test. This bonding strength in comparable with the tensile strength that is manifested by the bulk of an ordinary single crystal silicon substrate. This fact establishes the effectiveness of this invention.

As described in detail above with reference to the working example, the method of this invention permits a decrease in the amount of the polycrystalline silicon layer to be superposed and thereby a proportionate cut in the cost of production and allows production of a dielectric-separation substrate, which substrate avoids forming a warpage therein and giving rise to a void in the bonding face and, therefore, enjoys high bonding strength.

## Claims

1. A method for the production of a dielectric-separation substrate, characterized by comprising at least a step of forming grooves of required cross-sectional shapes in the surface portion of a single silicon substrate destined to form an device-forming side thereof and, at the same time, covering said grooves with an oxide film and then superposing a polycrystalline silicon layer thereon to the extent of causing said grooves to be buried completely therein, a step of grinding the surface of said superposed polycrystalline silicon layer so as to confer flatness thereon, a step of forming an oxide film on the flat surface of said polycrystalline silicon layer and then polishing the surface of said oxide film by the mechanochemical process thereby conferring flatness and smoothness thereon, a step of bonding a desired substrate prepared separately as a supporting member face to face to the flat and smooth surface of said oxide film, and a step of grinding and polishing said single crystal silicon substrate on said device-forming side from the rear side thereby forming in said single crystal silicon substrate single crystal silicon regions separated after the pattern of islands in an ocean by intervening portions of said oxide film.

2. A method according to claim 1, wherein said step of grinding the surface of said superposed polycrystalline silicon layer thereby conferring flatness thereon is followed by a step of polishing said flat surface thereby conferring substantial flatness and smoothness thereon, then superposing a thermal oxide film or a CVD oxide film on said substantially flat and smooth surface, and further polishing the surface of said oxide film thereby conferring flatness and smoothness thereon.
